# NEUE EUROPÄISCHE PATENTSCHRIFT

(11) **EP 2 117 081 B2**
(45) Veröffentlichungstag und Bekanntmachung des Hinweises auf die Entscheidung über den Einspruch: **06.10.2021**
(45) Hinweis auf die Patenterteilung: 07.11.2018
(21) Anmeldenummer: 09005696.1
(22) Anmeldetag: 23.04.2009
(51) Int. Cl.: H01R 13/24, G01R 1/067, G01R 1/073

(54) **Elektrisches Kontaktelement**
Electric contact element for touch contacting electric test items and corresponding contact assembly
Elément de contact électrique destiné à la mise en contact sensible d'échantillons électriques et agencement de mise en contact correspondant

(30) Priorität: 09.05.2008 DE 102008023761
(43) Veröffentlichungstag der Anmeldung: 11.11.2009
(73) Patentinhaber: Feinmetall GmbH, 71083 Herrenberg (DE)
(72) Erfinder: Weiland, Achim, 71157 Hildrizhausen (DE); Böhm, Gunther, 71154 Nufringen (DE)
(74) Vertreter: Clarenbach, Carl-Philipp

(56) Entgegenhaltungen:
- EP-A2- 0 500 227
- WO-A-2007/097559
- WO-A1-2007/029791
- US-A1- 2002 113 612
- US-A1- 2004 121 627
- US-A1- 2006 046 528
- US-A1- 2006 073 712
- US-A1- 2006 170 440
- US-A1- 2008 001 612

## Beschreibung

Die Erfindung betrifft ein elektrisches, längliches Kontaktelement zum Berührungskontaktieren von elektrischen Prüflingen mit den Merkmalen des Oberbegriffs des Anspruchs 1, mit zwei einer elektrischen Kontaktierung dienenden Endbereichen und einem zwischen den Endbereichen liegenden länglichen Zwischenbereich.

Derartige Kontaktelemente sind in Form von Federkontaktstiften oder Knicknadeln bekannt. Sie werden von einem Kontaktelementhalter gehalten und dienen dazu, mit einem Endbereich den elektrischen Prüfling zu kontaktieren und mit einem anderen Endbereich mit einer elektrischen Prüfeinrichtung in Kontakt zu stehen, sodass zum elektrischen Prüfling Prüfstromwege hergestellt werden und die Prüfeinrichtung den Prüfling auf einwandfreie elektrische Funktion testen kann. Die bekannten, als Federkontaktstifte oder Knicknadeln ausgebildeten Kontaktelemente weisen kreisförmige Querschnitte auf und entwickeln beim Aufsetzen auf Kontaktflächen des Prüflings Kontaktkräfte. Im Falle eines Federkontaktstiftes bestimmt sich seine Kontaktkraft durch einen schraubenfederbeaufschlagten Kolben. Bei einer Knicknadel resultiert die Kontaktkraft aus der Eigenelastizität des Nadelmaterials. Die Knicknadel wird durch den Kontaktierungsvorgang seitlich bogenförmig ausgelenkt und stellt sich nach der Kontaktierung in die Ausgangslage zurück. Im Zuge immer kompakter aufgebauter Prüflinge mit entsprechend kleiner werdenden elektrischen Kontaktabständen treten bei den erwähnten bekannten Kontaktelementen zunehmend Platzprobleme auf, das heißt, die kleinen Kontaktmittelabstände sind mit der bisherigen Technik nicht realisierbar oder führen dazu, dass sich Kontaktelemente ungewollt berühren und daher Kurzschlüsse erzeugen. Ferner führt eine aus Platzgründen erforderliche Querschnittsverkleinerung bei den Federkontaktstiften oder Knicknadeln zu einer geringeren Stromtragfähigkeit bei gleichzeitig abnehmender Kontaktkraft. Die geringen Querschnitte können zu einem Durchbrennen führen, wenn die Prüfströme eine bestimmte Stromstärke erfordern. Dieses Durchbrennen erfolgt zumeist mit Abstand zu Führungsdurchbrüchen, in denen beispielsweise die Knicknadeln geführt sind, da der mechanische Kontakt der Knicknadeln zu den Wandungen der Führungsdurchbrüche in unmittelbarer Nähe von diesen zu einer Wärmeabfuhr führt, die weiter beabstandet zum Führungsbereich nicht gegeben ist.

WO 2007029791 A1 zeigt ein Kontaktelement nach dem Oberbegriff des Anspruchs 1. US 2006/0170440 A1 offenbart ein Kontaktelement mit nur einem Endbereich zur Berührungskontaktierung.

Der Erfindung liegt daher die Aufgabe zugrunde, ein elektrisches Kontaktelement der eingangs genannten Art zu schaffen, das bei kleiner aber hinreichender Kontaktkraft einen großen Querschnitt, also eine hohe Stromtragfähigkeit, zur Verfügung stellt und insbesondere auch bei sehr eng liegenden Kontaktabständen einsetzbar ist.

Diese Aufgabe wird erfindungsgemäß durch ein Kontaktelement mit den Merkmalen des Anspruchs 1 gelöst. Weitere vorteilhafte Ausgestaltungen sind den Unteransprüchen zu entnehmen. Diese Aufgabe wird erfindungsgemäß dadurch gelöst, dass der Zwischenbereich im Wesentlichen einen rechteckigen Querschnitt aufweist und entlang seiner Längserstreckung lamelliert ausgebildet ist. Durch diese Ausgestaltung wird einerseits ein großer, von der Anzahl der Lamellen bestimmter Querschnitt zur Verfügung gestellt, sodass auch große Prüfströme ohne Überhitzung übertragen werden können. Ferner sorgt die Lamellierung für eine hinreichend kleine, jedoch für eine gute Kontaktierung ausreichende Kontaktkraft, da aufgrund der Lamellen eine gute Elastizität bei dem eingesetzten, elektrisch leitfähigen Werkstoff erzielt wird. Mit den erfindungsgemäßen, länglichen Kontaktelementen erfolgt eine so genannte "vertikale Kontaktierung", das heißt, es liegt jeweils ein etwa senkrecht zur Kontaktierebene ausgerichtetes Kontaktelement vor, das bei der Kontaktierung seitlich ausknicken kann, wobei der rechteckige Querschnitt ein sehr enges Anordnungsmuster einer Kontaktelementanordnung bei hoher Stromtragfähigkeit gestattet und der lamellierte Zwischenbereich ein leichtgängiges und dennoch eine hinreichende Kontaktkraft bereitstellendes Ausknicken ermöglicht. Die Formgebung des erfindungsgemäßen Kontaktelements erlaubt die Kontaktierung von Prüflingen, insbesondere Wafern, mit einem Kontaktmittelabstand von 40 µm und weniger. Der rechteckige Querschnitt des Zwischenbereichs bedeutet, dass die äußere Querschnittskontur diese Formgebung aufweist, das heißt, die Struktur innen liegender Lamellen wird dabei nicht berücksichtigt. Wenn im Zuge dieser Anmeldung von einem rechteckigen Querschnitt die Rede ist, unabhängig davon, zu welchem Teil des Kontaktelements dieser Querschnitt gehört, so ist stets auch ein quadratischer Querschnitt mit eingeschlossen.

Es ist vorgesehen, dass der lamellierte Zwischenbereich mindestens zwei, in Längsrichtung des Zwischenbereichs verlaufende Lamellen aufweist. Vorzugsweise sind mehr als zwei Lamellen vorgesehen, die sich in Längsrichtung des länglichen Kontaktelements erstrecken. Die Lamellen verlaufen insbesondere im Wesentlichen parallel zueinander, unabhängig davon, ob sie jeweils einen geradlinigen oder einen gebogenen Verlauf besitzen.

Erfindungsgemäß weisen benachbarte Lamellen zwischen sich mindestens einen Längsschlitz auf, das heißt, sie werden durch diesen mindestens einen Längsschlitz voneinander getrennt oder sind dadurch beabstandet. Erfolgt bei einer Kontaktierung eines Prüflings ein Knicken, also Biegen, des Kontaktelements, so ist es denkbar, dass benachbarte Lamellen unter Aufzehrung ihres durch den Längsschlitz gebildeten Abstandes zumindest abschnittsweise einander berühren, sodass also kein Abstand mehr zwischen ihnen besteht, jedoch eine Trennung.

Es ist vorgesehen, dass das Kontaktelement einen einstückigen Kontaktkörper aufweist. Demzufolge sind die beiden Endbereiche und der die Lamellen aufweisende Zwischenbereich einstückig ausgebildet.

Alternativ ist es auch möglich, dass das Kontaktelement einen mehrstückigen Kontaktkörper aufweist, da er im Bereich mindestens einer Kontaktierzone einen Kontaktiereinsatz aufweist. Der Kontaktiereinsatz dient der elektrischen Kontaktierung und kann zum Beispiel aus besonders gut elektrisch leitfähigem Material bestehen, während für den übrigen Kontaktkörperbereich ein anderes Material zum Einsatz gelangt.

Erfindungsgemäß weist das Kontaktelement eine Länge L, eine Breite B und eine Dicke D auf. Die Anordnung ist derart getroffen, dass die Länge L des Kontaktelements größer als seine Breite B ist und dass die Breite B des Kontaktelements größer als seine Dicke D ist. Im Wesentlichen ist das Kontaktelement daher erfindungsgemäß streifenförmig, nämlich als Kontaktstreifen ausgebildet.

Eine Weiterbildung der Erfindung sieht vor, dass die Lamellen jeweils eine Länge l, eine Breite b und eine Tiefe t aufweisen. Dabei ist die Länge leiner Lamelle vorzugsweise größer als ihre Breite b. Insbesondere kann ferner vorgesehen sein, dass die Breite b einer Lamelle größer als ihre Tiefe t ist.

Vorstehend wurde bereits erwähnt, dass der Querschnitt des Zwischenbereichs im Wesentlichen rechteckförmig ist. Insbesondere kann vorgesehen sein, dass das gesamte Kontaktelement im Wesentlichen einen rechteckförmigen Querschnitt ausbildet, dass also auch die beiden Endbereiche mit rechteckigem Querschnitt ausgebildet sind, wobei es nicht erforderlich ist, dass die rechteckigen Querschnitte des einen Endbereichs, des Zwischenbereichs und des anderen Endbereichs gleich groß sind oder eine gleiche Gestalt aufweisen.

Besonders bevorzugt ist vorgesehen, dass der Querschnitt mindestens einer der Lamellen im Wesentlich rechteckförmig ausgebildet ist. Bevorzugt weisen alle Lamellen einen rechteckförmigen Querschnitt auf.

Die Anordnung kann so getroffen sein, dass die Dicke D des Kontaktelement der Breite b mindestens einer der Lamellen, vorzugsweise der Breite b aller Lamellen entspricht, dass also durch die Dicke D des Kontaktelements die Breite b der einen Lamelle oder der Lamellen bestimmt wird.

Das Kontaktelement besteht bevorzugt aus einem elastischen Werkstoff. Hierdurch lässt sich die beim Kontaktieren erfolgende Biegung (Knickung) besonders gut realisieren. Es ist ferner stets gewährleistet, dass sich das Kontaktelement nach dem Kontaktieren, also im unbelasteten Zustand, in seine Ursprungsformgebung zurückstellt.

Es ist vorgesehen, dass die Lamellen im entspannten, nicht kontaktierten Zustand und/oder im gespannten, kontaktierten Zustand eine mindestens einen Bogen aufweisende Bogenform besitzen. Demzufolge kann das Kontaktelement "vorgebogen" sein, das heißt seine Lamellen besitzen im unbelasteten Zustand eine Bogenform, die sich beim Kontaktieren stärker krümmt. Alternativ kann auch vorgesehen sein, dass keine Vorbiegung besteht, sondern dass die Lamellen sich beim Belasten krümmen, also erst dann die Bogenform einnehmen.

Besonders bevorzugt ist vorgesehen, dass der mindestens eine Bogen der Bogenform in einer durch die Länge L des Kontaktelements und die Breite B des Kontaktelements definierten Ebene liegt. Dies hat den Vorteil, dass sich alle Lamellen gleichsinnig, also in dieselbe Richtung durchbiegen oder durchgebogen sind. Dies gilt auch für benachbarte Kontaktelemente, wodurch eine gegenseitige Berührung benachbarter Kontaktelemente und damit ein elektrischer Kurzschluss verhindert wird. Gemäß der vorstehenden Definition werden die einzelnen Lamellen um ihre kleinste Abmessung, also um die Tiefe t gebogen, was wiederum bedeutet, dass der gesamte Zwischenbereich um seine Breite B gebogen wird, die größer als die Dicke D des Kontaktelements ausgestaltet ist.

Es kann vorgesehen sein, dass die Querschnittsfläche und/oder Querschnittsform einer Lamelle über ihre Längserstreckung unterschiedlich ist/sind. Zusätzlich oder alternativ ist es auch möglich, dass die Querschnittsflächen und/oder Querschnittsformen der einzelnen Lamellen zueinander unterschiedlich sind.

Nach einer anderen Weiterbildung der Erfindung ist vorgesehen, dass der eine, insbesondere prüflingsseitige Endbereich, eine - bezogen auf die Breite B des Kontaktelements - außermittig liegende erste Kontaktierzone aufweist. Insbesondere kann der gesamte eine Endbereich oder ein Großteil davon außermittig in Bezug auf die Breite B des Kontaktelements liegen. Diese Außermittigkeit initiiert eine Durchbiegung in einer definierten Richtung, sodass die Knickrichtung hiermit vorgegeben wird.

Der andere Endbereich kann - nach einem weiteren Ausführungsbeispiel - eine - bezogen auf die Breite des Kontaktelements - mittig liegende zweite Kontaktierzone aufweisen. Hierbei handelt es sich insbesondere um den prüflingsabgewandten Endbereich.

Es ist vorteilhaft, wenn die erste und/oder zweite Kontaktierzone eine beziehungsweise jeweils eine sich von zwei Seiten verjüngende Kontaktspitze aufweist. Dies führt insbesondere bei der Kontaktierung zu einem Linienkontakt beziehungsweise zu einer im Wesentlichen rechteckförmigen Berührungsfläche.

Nach einer Weiterbildung der Erfindung ist vorgesehen, dass das Kontaktelement zwei Längsseiten besitzt, von denen eine einen gekröpften Verlauf zur Ausbildung eines seitlichen Versatzes des einen Endbereichs aufweist. Hierdurch wird insbesondere die vorstehend beschriebene Außermittigkeit der ersten Kontaktierzone ausgebildet. Durch den gekröpften Verlauf der einen Längsseite wird insbesondere eine Rückhaltestufe ausgebildet. Diese dient dazu, das Kontaktelement in einem Kontaktelementhalter zu halten, sodass es nicht aus diesem herausrutschen kann.

Das Kontaktelement weist bevorzugt mindestens einen Abschnitt auf, der mit einer elektrisch isolierenden Beschichtung und/oder mit einer Kontaktierbeschichtung versehen ist. Die Kontaktierbeschichtung kann im Stoffschluss, beispielsweise durch Aufschmelzen auf das Kontaktelement, aufgebracht sein.

Ferner ist es vorteilhaft, wenn mindestens einer der Endbereiche eine Krümmung und/oder Neigung aufweist, die dem Bogen der Bogenform entgegengesetzt gerichtet ist. Hierdurch wird beim Aufsetzen des Kontaktelements auf den Prüfling im Zuge der in Längserstreckung des Kontaktelements erfolgenden, einfedernden Kontaktierung des Prüflings der genannte Endbereich eine Kippbewegung durchführen, die in Bezug auf die Berührungskontaktierstelle als eine Kratzbewegung in Erscheinung tritt, wodurch ein besonders guter elektrischer Kontakt erzielt werden kann, auch wenn die Kontaktflächen verschmutzt sind und/oder Oxydschichten aufweisen.

Ferner ist es vorteilhaft, wenn mindestens einer der Endbereiche, insbesondere der außermittig liegende Endbereich, einen im Wesentlichen rechteckigen Querschnitt aufweist. Dieser Querschnitt wirkt bevorzugt mit einem Führungsloch/Führungsdurchbruch zusammen, das/der ebenfalls im Querschnitt rechteckförmig ausgebildet ist. Hierauf wird nachstehend noch näher eingegangen.

Die Erfindung betrifft ferner eine elektrische Kontaktieranordnung mit mindestens einem Kontaktelement, so wie es vorstehend beschrieben wurde, und mit einem Kontaktelementhalter, der mindestens zwei beabstandet zueinander angeordnete Führungen für das Kontaktelement aufweist, von denen mindestens eine mindestens einen Führungsdurchbruch besitzt, der von dem Kontaktelement durchsetzt wird. Die beiden Führungen können insbesondere als Führungsplatten ausgebildet sein, wobei das Kontaktelement in seinen beiden Endbereichen von den Führungen gehalten wird, in dem beide oder zumindest ein Endbereich einen entsprechenden Führungsdurchbruch durchsetzt.

Wie bereits erwähnt, ist vorzugsweise vorgesehen, dass mindestens einer der Führungsdurchbrüche einen im Wesentlichen rechteckigen Querschnitt aufweist. Die Anordnung ist so getroffen, dass der rechteckförmige Endbereich in dem rechteckförmigen Führungsdurchbruch nur mit sehr kleinem Spiel einliegt, sodass ein Einsetzen des Kontaktelements in den Führungsdurchbruch möglich ist und ferner eine Bewegung beim Kontaktieren und beim Aufheben der Kontaktierung ermöglicht wird.

Der einen rechteckigen Querschnitt aufweisende Führungsdurchbruch weist vorzugsweise vier Führungsdurchbruchwände auf, von denen eine erste Führungsdurchbruchwand einer zweiten Führungsdurchbruchwand gegenüberliegt.

Es ist insbesondere vorgesehen, dass das Kontaktelement im entspannten, nicht kontaktiertem Zustand derart in dem Führungsdurchbruch gehalten ist, dass eine der Längsseiten des Kontaktelements an einer ersten Stelle der ersten Führungsdurchbruchwand und die andere der Längsseite des Kontaktelements an einer zweiten Stelle der zweiten Führungsdurchbruchwand anliegt, wobei die beiden Stellen einen axialen Abstand zueinander aufweisen. Das Wort "axial" ist in Bezug auf die Längserstreckung des Kontaktelements zu interpretieren. Wird mit dem Kontaktelement nunmehr ein Prüfling kontaktiert, also wird es gespannt und befindet sich demzufolge im kontaktieren Zustand, dann wird es derart in dem Führungsdurchbruch geführt, dass die im entspannten Zustand bisher an der ersten Stelle der ersten Führungsdurchbruchwand anliegenden Längsseite nunmehr an einer dritten Stelle der ersten Führungsdurchbruchwand anliegt und dass die bisher an der zweiten Stelle der zweiten Führungsdurchbruchwand anliegende Längsseite des Kontaktelements nunmehr an einer vierten Stelle der zweiten Führungsdurchbruchwand anliegt. Hierdurch wird deutlich, dass bei der Kontaktierung eine Neigebewegung des Kontaktelements im Bereich des Führungsdurchbruchs erfolgt, mit der Folge, dass die erwähnte Kratzbewegung vorliegt, dass also die Kontaktierzone auf einer Kontaktfläche des Prüflings entlangkratzt und damit einen sehr niederohmigen elektrischen Verbindungsweg schafft, wobei das Kontaktelement im entspannten, also nichtkontaktierten Zustand durch die erwähnte Anlage an den Führungsdurchbruchwänden eine definierte Lage einnimmt und dass auch im gespannten, also kontaktierten Zustand wiederum eine definierte Endlage eingenommen wird, dass also die auftretende Nickbewegung reproduzierbar begrenzt wird. Hinsichtlich des Kontaktiervorgangs bedeutet diese Nickbewegung einen "Kantenumschlag", das heißt die der elektrischen Kontaktierung dienende Kontaktierzone kippt um die Kontaktkante, was zu besonders guten Kontaktierergebnissen führt. Hierbei ist zu bemerken, dass die Kratzbewegung selbstverständlich aufgrund der sehr kleinen Abmessungen der hier beteiligten Bauteile und aufgrund des extrem kleinen Kontaktabstands beim Prüfling nur mikroskopisch klein ist, was jedoch für ein gutes elektrisches Ergebnis völlig ausreicht.

Die Zeichnungen veranschaulichen die Erfindung anhand eines Ausführungsbeispiels, und zwar zeigt:
- Figur 1: eine Draufsicht auf ein Kontaktelement,
- Figur 2: einen einem Prüfling zuordenbaren Endbereich des Kontaktelements der Figur 1,
- Figur 3: das Kontaktelement der Figur 1 im entspannten, nicht kontaktierten und im gespannten, kontaktierten Zustand, und
- Figur 4: einen Einsetzvorgang eines Kontaktelements in eine Kontaktieranordnung in drei Schritten.

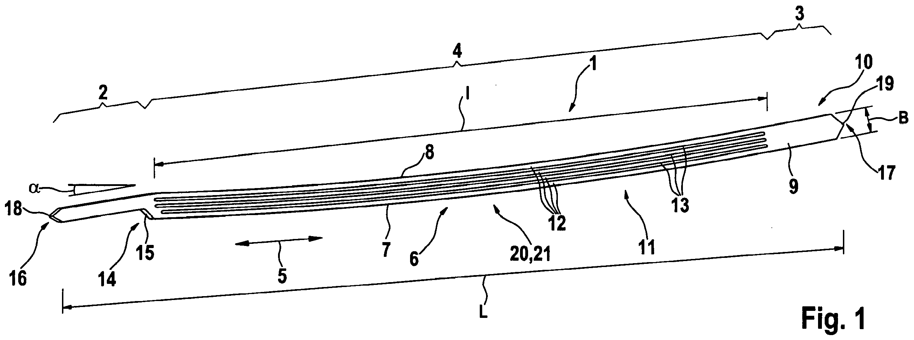

Die Figur 1 zeigt ein elektrisches, längliches Kontaktelement 1, das der Berührungskontaktierung von elektrischen Prüflingen dient. Das Kontaktelement 1 weist zwei Endbereiche 2 und 3 und einen dazwischen liegenden, länglichen Zwischenbereich 4 auf. Auch die beiden Endbereiche 2 und 3 sind länglich gestaltet. Insgesamt weist demzufolge das Kontaktelement eine Längserstreckung auf, die mit einem Doppelpfeil 5 angedeutet ist.

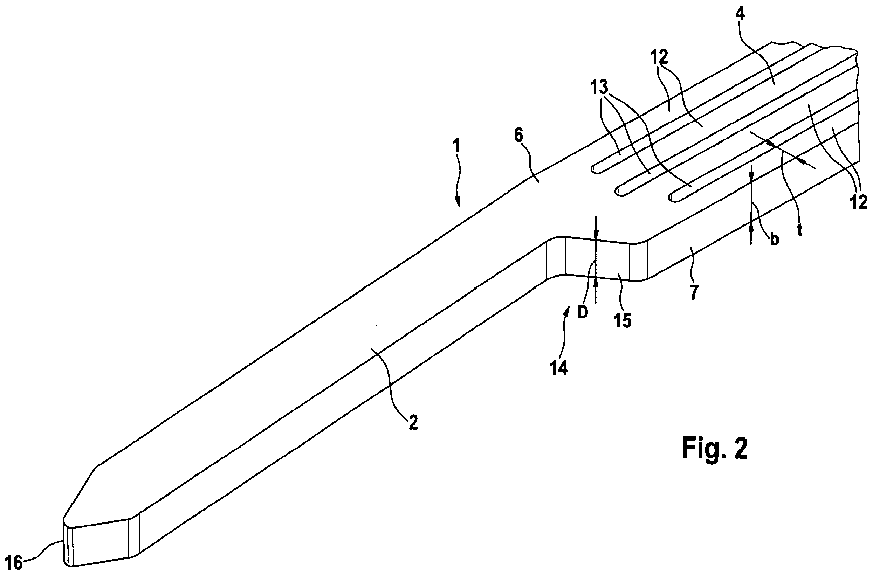

Das Kontaktelement 1 ist einstückig ausgebildet. Es wird von einem einstückigen Kontaktkörper 6 gebildet. Das Kontaktelement 1 weist zwei Längsseiten 7, 8 sowie eine Vorderseite 9 und eine der Vorderseite gegenüberliegende Rückseite 10 auf. Es besitzt eine Länge L, eine Breite B und eine Dicke D (Figur 2). Aufgrund seiner länglichen Gestalt ist das Kontaktelement 1 im Wesentlichen als Kontaktstreifen 11 ausgebildet. Letzteres ergibt sich insbesondere auch daraus, dass die Länge L größer als die Breite B und die Breite B größer als die Dicke D ausgebildet ist.

Wie den Figuren zu entnehmen ist, ist der Zwischenbereich 4 lamelliert ausgebildet, das heißt, er weist Lamellen 12 auf, die sich in Längserstreckungsrichtung (Doppelpfeil 5) erstrecken. Die Lamellen 12 laufen vorzugsweise parallel zueinander (unabhängig davon, dass sie eine Bogenform besitzen, auf die nachstehend noch näher eingegangen wird). Benachbarte Lamellen 12 werden jeweils von einem Längsschlitz 13 voneinander getrennt. Die Anordnung ist vorzugsweise derart getroffen, dass die Lamellen 12 eine Länge I (Figur 1), eine Breite b und eine Tiefe t aufweisen. Die Länge I ist größer als die Breite b. Die Breite b ist größer als die Tiefe t (Figur 2). Ferner ist der Figur 2 zu entnehmen, dass die Breite b der Lamellen 12 ebenso groß ist wie die Dicke D des Kontaktelements. In weiteren, nicht dargestellten Ausführungsformen kann auch vorgesehen sein, dass die Breite b der Lamellen 12 oder einer der Lamellen 12 größer oder kleiner als die Dicke D des Kontaktelements 1 ist. Die Breite b der Lamellen 12 kann 10 bis 100 µm, insbesondere 30 µm, und die Tiefe t 10 bis 50 µm, insbesondere 20 µm, betragen. Im dargestellten Ausführungsbeispiel weist das Kontaktelement 1 vier Lamellen 12 auf, zwischen den drei Längsschlitze 13 liegen. Es ist selbstverständlich auch möglich, eine andere Anzahl von Lamellen 12 auszubilden. Die kleinste Lamellenanzahl beträgt zwei.

Die Längsseite 7 des Kontaktelements 1 weist einen gekröpften Verlauf auf, was zu einem seitlichen Versatz des Endbereichs 2 führt. Die Kröpfung ist in Figur 1 mit dem Bezugszeichen 14 gekennzeichnet. Durch die Kröpfung 14 verläuft der Endbereich 2 außermittig, das heißt, bezogen auf die Längsmitte der Vorderseite 9 liegt der Endbereich 2 seitlich versetzt. Durch die Versetzung wird eine Rückhaltestufe 15 ausgebildet. Der Endbereich 2 weist eine erste Kontaktierzone 16 und der Endbereich 3 eine zweite Kontaktierzone 17 auf.

Die erste und die zweite Kontaktierzone 16, 17 sind jeweils von sich von zwei Seiten verjüngenden Kontaktspitzen 18, 19 gebildet. Die Längskämme der Kontaktspitzen 18, 19 verlaufen in Richtung der Dicke D des Kontaktelements 1. Der Endbereich 2 liegt aufgrund der Kröpfung 14 größtenteils außermittig und die zweite Kontaktierzone 17 mittig in Bezug auf die Breite B des Kontaktelements 1.

Das gesamte Kontaktelement 1 weist einen rechteckigen Querschnitt auf. Dies gilt sowohl für den Endbereich 2, für den Endbereich 3, für den Zwischenbereich 4 (als Gesamtkontur gesehen) als auch für die einzelnen Lamellen 12. Alternativ sind auch andere Querschnittsformen, zum Beispiel kreisförmige, möglich.

Der Figur 1 ist zu entnehmen, dass sich das Kontaktelement 1 im dort dargestellten unbelasteten Zustand nicht geradlinig erstreckt, sondern dass es einen Bogen 20 und demzufolge eine Bogenform 21 besitzt. Die einzelnen Lamellen 12 verlaufen daher bogenförmig. Ferner ist erkennbar, dass der Endbereich 2 eine Neigung, angedeutet durch den in Figur 1 eingezeichneten Winkel α besitzt, die dem Bogen 20 entgegengesetzt gerichtet ist. Dies bedeutet, dass die erste Kontaktzone 16 etwa mittig zur Breite B liegt, obwohl die Anbindung des Endbereichs 2 an den Zwischenbereich 4 - wie erwähnt - außermittig liegt.

Das Kontaktelement 1 besteht aus einem elastischen, elektrisch leitfähigen Werkstoff.

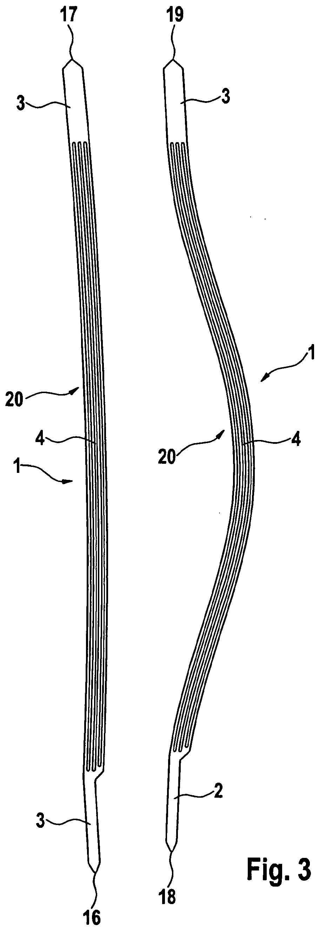

Der Figur 3 ist zu entnehmen, dass sich das Kontaktelement 1 bei Belastung verstärkt durchbiegt, das heißt, die Vorbiegung im unbelasteten Zustand (links in Figur 3) wird durch Belastung, also beim Kontaktieren eines nicht dargestellten elektrischen Prüflings, vergrößert (rechts in Figur 3). Die einzelnen Lamellen 12 werden in einer Ebene gebogen, die parallel zur Ebene der Vorderseite 9 beziehungsweise Rückseite 10 des Kontaktelements 1 liegt.

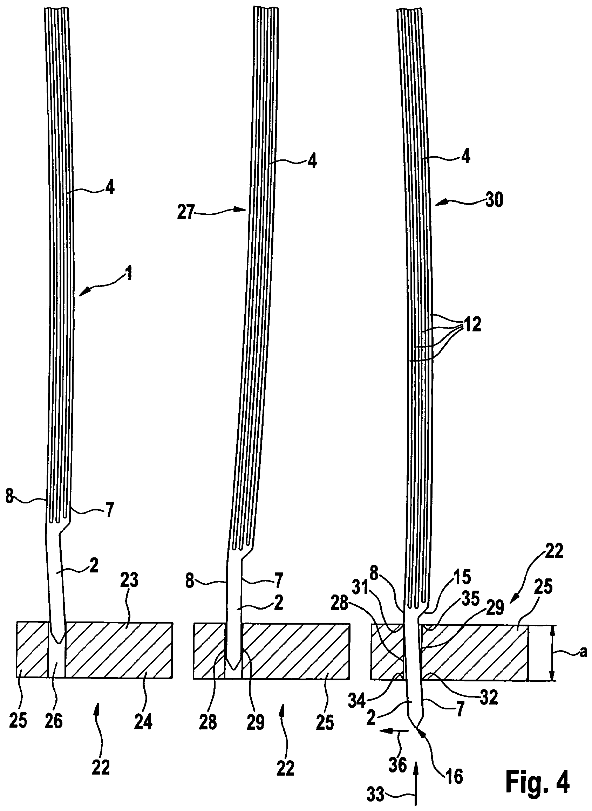

Die Figur 4 verdeutlicht eine Kontaktieranordnung 22, die mindestens ein Kontaktelement 1 und einen Kontaktelementhalter 23 aufweist. In der Figur 4 ist ein und dieselbe Baugruppe dreimal nebeneinander dargestellt, um einen Einsetzvorgang des Kontaktelements 1 in den Kontaktelementhalter 23 zu verdeutlichen. Es ist erkennbar, dass der Kontaktelementhalter 23 eine Führung 24 in Form einer Führungsplatte 25 aufweist. Die Führung 24 besitzt einen Führungsdurchbruch 26, der einen rechteckigen Querschnitt aufweist, wobei dieser rechteckige Querschnitt im Wesentlichen dem rechteckigen Querschnitt des Endbereichs 2 des Kontaktelements 1 angepasst ist, sodass nur ein geringes Spiel besteht, wenn sich der Endbereich 2 im Führungsdurchbruch 26 befindet. Insbesondere kann vorgesehen sein - was jedoch in der Figur 4 nicht dargestellt ist -, dass auch der andere Endbereich 3 in einer Führung 24 geführt ist.

Aus der Folge der einzelnen Darstellungen der Figur 4 wird deutlich, wie ein Kontaktelement 1 in den Kontaktelementhalter 23 eingesetzt wird, das Kontaktelement ist dabei in seinem Endbereich 3 gehalten (nicht dargestellt). Das Einsetzen erfolgt derart, dass zunächst der vordere Spitzenbereich des Endbereichs 2 ein Stück weit in den Führungsdurchbruch 26 eingesteckt wird. Da der Endbereich 23 eine Neigung (Winkel α) aufweist, ist es erforderlich, das Kontaktelement 1 gegenüber seiner entspannten Form weiter durchzubiegen, wie es mit Pfeil 27 angedeutet ist (mittlere Darstellung in Figur 4), sodass die Längsseiten 7 und 8 des Endbereichs 2 parallel zu ersten und zweiten Führungsdurchbruchwänden 28 und 29 des Führungsdurchbruchs 26 verlaufen. Nunmehr wird der Endbereich 2 derart weit in den Führungsdurchbruch 26 eingeschoben, dass die Kontaktzone 16 - gemäß der rechten Darstellung der Figur 4 - ein gutes Stück aus der Führung 24 nach unten herausschaut. Anschließend entspannt sich das Kontaktelement 1 ein wenig, sodass sich der Bogen verkleinert (Pfeil 30), wodurch eine leichte Vorspannung auf den Führungsdurchbruch 26 ausgeübt wird. Ein derart montiertes Kontaktelement 1 liegt demzufolge - gemäß der rechten Darstellung der Figur 4 - derart in dem Führungsdurchbruch 26, dass die Längsseite 8 an einer Stelle 31 der ersten Führungsdurchbruchwand 28 und die andere Längsseite 7 des Kontaktelements 1 an einer Stelle 32 der zweiten Führungsdurchbruchwand 29 anliegt, wobei die beiden Stellen 31, 32 einen axialen Abstand a voneinander aufweisen.

Wird nun bei einer Kontaktierung die Kontaktzone 16 für eine Berührungskontaktierung gegen einen nicht dargestellten elektrischen Prüfling gedrückt (Druckkraft 33), so werden sich die Lamellen 12 durchbiegen beziehungsweise stärker durchbiegen, mit der Folge, dass eine Verschwenkung des Endbereichs 2 im Führungsdurchbruch 26 derart erfolgt, dass in diesem gespannten, kontaktierten Zustand der Endbereich 2 des Kontaktelements 1 derart in dem Führungsdurchbruch 26 gehalten ist, dass die im entspannten Zustand (rechte Darstellung in Figur 4) bisher an der Stelle 31 der ersten Führungswand 28 anliegende Längsseite 8 nunmehr an einer anderen Stelle 34 der ersten Führungsdurchbruchwand 28 anliegt und dass die bisher an der zweiten Führungsdurchbruchwand 29 an der Stelle 32 anliegende Längsseite 7 nunmehr ebenfalls an einer anderen Stelle 35 der zweiten Führungsdurchbruchwand 29 anliegt. Die beiden Stellen 34 und 35 weisen ebenfalls einen axialen Abstand a auf. Es erfolgt quasi ein Kantenwechsel. Es ist verständlich, dass sich aufgrund dieses Kantenwechsels die erste Kontaktierzone 16 in Richtung des Pfeils 36 verlagert, mit der Folge, dass eine Kratzbewegung auf der Kontaktstelle des nicht dargestellten elektrischen Prüflings erfolgt. Hierdurch können Verschmutzungen beim Kontaktieren beseitigt und auch mögliche Oxidationsstellen entfernt werden, sodass eine sehr gute elektrische Kontaktierung vorliegt.

Aufgrund der Erfindung ist ein Kontaktelement 1 realisiert, dass mehrere, parallel angeordnete Streifen mit rechteckigem Querschnitt, die Lamellen 12, aufweist. Die Lamellen 12 sind so miteinander verbunden, dass eine resultierende Knickbewegung des Kontaktelements 1 der der einzelnen Lamellen 12 entspricht. Um ein Ausknicken beim Kontaktieren zu begünstigen, ist das Kontaktelement leicht vorgebogen ausgebildet. Durch eine entsprechend außermittige Krafteinleitung, insbesondere aufgrund des Versatzes des Endbereichs 2 gegenüber der Mitte bezogen auf die Breite B des Kontaktelements, und die erwähnte leichte Vorbiegung ist ein eindeutiges Knickverhalten des Kontaktelements 1 vorgegeben. Da sich das Kontaktelement 1 im Endbereich 2 verjüngt, ergibt sich eine Rückhaltefunktion in der Führung 24 aufgrund der ausgebildeten Rückhaltestufe 15. Die der Krümmung (Bogen 20) entgegenstehende Neigung des Endbereichs 2 ist für folgende Funktionen verantwortlich: definierte Anlagekanten gemäß Figur 4 und dadurch positionsgenau. Leichte Klemmung in der Führung 24 und dadurch eine Herausfallsicherung nach oben (hinten). Beim Ausknicken (Kontaktieren) findet ein Kantenumschlag statt und die Spitze (Kontaktzone 16) führt einen so genannten Scrub aus. Beim Montieren wird das Kontaktelement 1 leicht geknickt und dadurch richtet sich der Endbereich 2 parallel zum Führungsdurchbruch 26 aus. Hierdurch kann eingefädelt werden.

Aufgrund der Lamellen 12 ist ein großer Querschnitt und damit ein geringer ohmscher Widerstand gewährleistet. Gleichzeitig liegt eine flache Bauform mit geringer Kontaktkraft vor. Es können sehr eng beieinander liegende Kontakte eines Prüflings kontaktiert werden, beispielsweise mindestens ein 40 µm-Pitch. Die Gesamtlänge L kann beispielsweise 3,5 mm betragen. Die Kontaktkraft beträgt cirka 27 mN. Der elektrische Widerstand beträgt cirka 0,3 Ohm.

## Patentansprüche

1. Elektrisches, als Kontaktstreifen (11) längserstrecktes Kontaktelement (1) zum Berührungskontaktieren von elektrischen Prüflingen, mit einem Kontaktkörper (6), der zwei einer elektrischen Berührungskontaktierung dienende Endbereiche (2,3) und einen zwischen den Endbereichen (2,3) liegenden, länglichen Zwischenbereich (4) aufweist, wobei der Zwischenbereich (4) einen im Wesentlichen rechteckigen Querschnitt aufweist und entlang seiner Längserstreckung lamelliert ausgebildet ist, derart, dass benachbarte Lamellen (12) durch mindestens einen Längsschlitz (13) voneinander getrennt oder beabstandet sind, wobei der Kontaktkörper (6) einstückig ausgebildet ist, wobei die Länge L des Kontaktelements (1) größer als seine Breite B und die Breite B des Kontaktelements (1) größer als seine Dicke D ist, **dadurch gekennzeichnet, dass** die Lamellen (12) im entspannten, nicht kontaktierten Zustand und/oder im gespannten, kontaktierten Zustand eine mindestens einen Bogen (20) aufweisende Bogenform (21) besitzen, und dass der mindestens eine Bogen (20) der Bogenform (21) in einer durch die Länge L des Kontaktelements (1) und die Breite B des Kontaktelements (1) definierten Ebene liegt.

2. Kontaktelement nach Anspruch 1, **dadurch gekennzeichnet, dass** die Länge I einer Lamelle (12) größer als ihre Breite b ist.

3. Kontaktelement nach einem der vorhergehenden Ansprüche, **dadurch gekennzeichnet, dass** die Breite b einer Lamelle (12) größer als ihre Tiefe t ist.

4. Kontaktelement nach einem der vorhergehenden Ansprüche, **dadurch gekennzeichnet, dass** der Querschnitt des gesamten Kontaktelements im Wesentlichen rechteckförmig ausgebildet ist.

5. Kontaktelement nach einem der vorhergehenden Ansprüche, **dadurch gekennzeichnet, dass** der Querschnitt mindestens einer der Lamellen (12) im Wesentlichen rechteckförmig ausgebildet ist.

6. Kontaktelement nach einem der vorhergehenden Ansprüche, **dadurch gekennzeichnet, dass** seine Dicke D die Breite b mindestens einer der Lamellen (12) bildet.

7. Kontaktelement nach einem der vorhergehenden Ansprüche, **dadurch gekennzeichnet, dass** es aus einem elastischen Werkstoff besteht.

8. Kontaktelement nach einem der vorhergehenden Ansprüche, **dadurch gekennzeichnet, dass** die Querschnittsfläche und/oder Querschnittsform einer Lamelle (12) über ihre Längserstreckung unterschiedlich ist/sind.

9. Kontaktelement nach einem der vorhergehenden Ansprüche, **dadurch gekennzeichnet, dass** die Querschnittsflächen und/oder Querschnittsformen der Lamellen (12) untereinander unterschiedlich sind.

10. Kontaktelement nach einem der vorhergehenden Ansprüche, **dadurch gekennzeichnet, dass** der eine, insbesondere prüflingsseitige Endbereich (2), eine - bezogen auf die Breite B des Kontaktelements (1) - außermittig liegende erste Kontaktierzone (16) aufweist.

11. Kontaktelement nach einem der vorhergehenden Ansprüche, **dadurch gekennzeichnet, dass** der andere Endbereich (3) eine - bezogen auf die Breite B des Kontaktelements (1) - mittig liegende zweite Kontaktierzone (17) aufweist.

12. Kontaktelement nach einem der vorhergehenden Ansprüche, **dadurch gekennzeichnet, dass** die erste und/oder zweite Kontaktierzone (16,17) eine beziehungsweise jeweils eine sich von zwei Seiten verjüngende Kontaktspitze (18,19) aufweist.

13. Kontaktelement nach einem der vorhergehenden Ansprüche, **dadurch gekennzeichnet, dass** es zwei Längsseiten (7,8) besitzt, von denen eine einen gekröpften Verlauf zur Ausbildung eines seitlichen Versatzes des einen Endbereichs (2) aufweist.

14. Kontaktelement nach Anspruch 13, **dadurch gekennzeichnet, dass** durch den gekröpften Verlauf der einen Längsseite eine Rückhaltestufe (15) gebildet ist.

15. Kontaktelement nach einem der vorhergehenden Ansprüche, **gekennzeichnet durch** mindestens einen Abschnitt, der mit einer elektrisch isolierenden Beschichtung und/oder mit einer Kontaktierbeschichtung versehen ist.

16. Kontaktelement nach einem der vorhergehenden Ansprüche, **dadurch gekennzeichnet, dass** mindestens einer der Endbereiche (2,3) eine Krümmung und/oder Neigung aufweist, die dem Bogen (20) der Bogenform (21) entgegengesetzt gerichtet ist.

17. Kontaktelement nach einem der vorhergehenden Ansprüche, **dadurch gekennzeichnet, dass** mindestens einer der Endbereiche (2,3) einen im Wesentlichen rechteckigen Querschnitt aufweist.

18. Kontaktelement nach Anspruch 10, **dadurch gekennzeichnet, dass** der außermittig liegende Endbereich (2), einen im Wesentlichen rechteckigen Querschnitt aufweist.

19. Kontaktelement nach einem der vorhergehenden Ansprüche, **dadurch gekennzeichnet, dass** die Lamellen (12) unterschiedliche Längen I und/oder unterschiedliche Bogenformen aufweisen.

20. Elektrische Kontaktieranordnung mit mindestens einem Kontaktelement (1) nach einem der vorhergehenden Ansprüche und mit einem Kontaktelementhalter (23), der mindestens zwei beabstandet zueinander angeordnete Führungen (24) für das Kontaktelement (1) aufweist, von denen mindestens eine mindestens einen Führungsdurchbruch (26) besitzt, der von dem Kontaktelement (1) durchsetzt wird.

21. Kontaktieranordnung nach Anspruch 20, **dadurch gekennzeichnet, dass** mindestens einer der Führungsdurchbrüche (26) einen im Wesentlichen rechteckigen Querschnitt aufweist.

22. Kontaktieranordnung nach einem der Ansprüche 20 bis 21, **dadurch gekennzeichnet, dass** der einen rechteckigen Querschnitt aufweisende Führungsdurchbruch (26) vier Führungsdurchbruchwände aufweist, von denen eine erste Führungsdurchbruchwand (28) einer zweiten Führungsdurchbruchwand (29) gegenüberliegt.

23. Kontaktieranordnung nach einem der Ansprüche 20 bis 22, **dadurch gekennzeichnet, dass** das Kontaktelement (1) im entspannten, nicht kontaktierten Zustand derart in dem Führungsdurchbruch (26) gehalten ist, dass eine der Längsseiten (8,7) des Kontaktelements (1) an einer Stelle der ersten Führungsdurchbruchwand (28) und die andere der Längsseiten (7,8) des Kontaktelements (1) an einer Stelle der zweiten Führungsdurchbruchwand (29) anliegt, wobei die beiden Stellen einen axialem Abstand zueinander aufweisen.

24. Kontaktieranordnung nach einem der Ansprüche 20 bis 23, **dadurch gekennzeichnet, dass** das Kontaktelement (1) im gespannten, kontaktierten Zustand derart in dem Führungsdurchbruch (26) gehalten ist, dass die im entspannten Zustand bisher an der Stelle der ersten Führungsdurchbruchwand (28) anliegende Längsseite (8,7) nunmehr an einer anderen Stelle der ersten Führungsdurchbruchwand (28) anliegt und dass die bisher an der Stelle der zweiten Führungsdurchbruchwand (29) anliegende Längsseite (7,8) des Kontaktelements (1) nunmehr an einer anderen Stelle der zweiten Führungsdurchbruchwand (29) anliegt.

## Claims

1. Electrical, elongated contact element (1) designed as contact strip (11) for touch-contacting electrical test specimen, comprising a contact body (6), which has two end regions (2, 3) serving for electrical touch-contacting and an elongate intermediate region (4) positioned between the end regions (2, 3), the intermediate region (4) having a substantially rectangular cross section and being formed lamellated along the longitudinal extent thereof, in such a way that adjacent lamellae (12) are separated or spaced apart from one another by at least one longitudinal slit (13), the contact body (6) being formed in a single piece, the length L of the contact element (1) being greater than the width B thereof and the width B of the contact element (1) being greater than the thickness D thereof, **characterised in that** the lamellae (12), in the relaxed, uncontacted state and/or in the tensioned, contacted state, have an arc shape (21) having at least one arc (20), and **in that** the at least one arc (20) of the arc shape (21) is positioned in a plane defined by the length L of the contact element (1) and the width B of the contact element (1).

2. Contact element according to claim 1, **characterised in that** the length 1 of a lamella (12) is greater than the width b thereof.

3. Contact element according to any of the preceding claims, **characterised in that** the width b of a lamella (12) is greater than the depth t thereof.

4. Contact element according to any of the preceding claims, **characterised in that** the cross section of the entire contact element is formed substantially rectangular.

5. Contact element according to any of the preceding claims, **characterised in that** the cross section of at least one of the lamellae (12) is formed substantially rectangular.

6. Contact element according to any of the preceding claims, **characterised in that** the thickness D thereof forms the width b of at least one of the lamellae (12).

7. Contact element according to any of the preceding claims, **characterised in that** it consists of an elastic material.

8. Contact element according to any of the preceding claims, **characterised in that** the cross-sectional area and/or cross-sectional shape of a lamella (12) vary over the longitudinal extension thereof.

9. Contact element according to any of the preceding claims, **characterised in that** the cross-sectional areas and/or cross-sectional shapes of the lamellae (12) differ from one another.

10. Contact element according to any of the preceding claims, **characterised in that** one end region (2), in particular the end region directed towards the test specimen, has a first contacting zone (16) positioned eccentrically with respect to the width B of the contact element (1).

11. Contact element according to any of the preceding claims, **characterised in that** the other end region (3) has a second contacting zone (17) positioned centrally with respect to the width B of the contact element (1).

12. Contact element according to any of the preceding claims, **characterised in that** the first and/or second contacting zone (16, 17) has or each have a contact tip (18, 19) tapering from two sides.

13. Contact element according to any of the preceding claims, **characterised in that** it has two longitudinal faces (7, 8), of which one has a cranked extension to form a lateral offset of the one end region (2).

14. Contact element according to claim 13, **characterised in that** a retention step (15) is formed by the cranked extension of the one longitudinal face.

15. Contact element according to any of the preceding claims, **characterised by** at least one portion provided with an electrically insulating coating and/or with a contacting coating.

16. Contact element according to any of the preceding claims, **characterised in that** at least one of the end regions (2, 3) has a curvature and/or inclination directed counter to the arc (20) of the arc shape (21).

17. Contact element according to any of the preceding claims, **characterised in that** at least one of the end regions (2, 3) has a substantially rectangular cross section.

18. Contact element according to claim 10, **characterised in that** the eccentrically positioned end region (2) has a substantially rectangular cross section.

19. Contact element according to any of the preceding claims, **characterised in that** the lamellae (12) have different lengths 1 and/or different arc shapes.

20. Electrical contacting arrangement comprising at least one contact element (1) according to any of the preceding claims and comprising a contact element holder (23) which has at least two guides (24) for the contact element (1), which are arranged spaced apart from one another and at least one of which has at least one guide opening (26) which is passed through by the contact element (1).

21. Contacting arrangement according to claim 20, **characterised in that** at least one of the guide openings (26) has a substantially rectangular cross section.

22. Contacting arrangement according to any of claims 20 to 21, **characterised in that** the guide opening (26) having a rectangular cross section has four guide opening walls, of which a first guide opening wall (28) is opposite a second guide opening wall (29).

23. Contacting arrangement according to any of claims 20 to 22, **characterised in that** the contact element (1), in the relaxed, uncontacted state, is held in the guide opening (26) in such a way that one of the longitudinal faces (8, 7) of the contact element (1) abuts on a point of the first guide opening wall (28) and the other of the longitudinal faces (7, 8) of the contact element (1) abuts on a point of the second guide opening wall (29), the two points having an axial spacing from one another.

24. Contacting arrangement according to any of claims 20 to 23, **characterised in that** the contact element (1), in the tensioned, contacted state, is held in the guide opening (26) in such a way that the longitudinal face (8, 7), which in the relaxed state thus far has been abutting on the point of the first guide opening wall (28), is now abutting on a different point of the first guide opening wall (28), and that the longitudinal face (7, 8) of the contact element (1), which thus far has been abutting on the point of the second guide opening wall (29), is now abutting on a different point of the second guide opening wall (29).

## Revendications

1. Élément de contact (1) électrique oblong, réalisé en tant que bande de contact (11), destiné à la mise en contact d'échantillons électriques, comportant un corps de contact (6) qui présente deux parties terminales (2, 3) servant à une mise en contact électrique et une partie intermédiaire (4) allongée, située entre les parties terminales (2, 3), la partie intermédiaire (4) présentant une section transversale essentiellement rectangulaire et étant réalisée de manière lamellaire le long de son étendue longitudinale de façon à ce que des lamelles avoisinantes (12) soient séparées ou distancées les unes des autres par au moins une fente longitudinale (13), le corps de contact (6) étant réalisé d'un seul tenant, la longueur L de l'élément de contact (1) étant plus grande que sa largeur B et la largeur B de l'élément de contact (1) étant plus grande que son épaisseur D, **caractérisé en ce que** les lamelles (12), à l'état détendu non mis en contact et/ou à l'état tendu mis en contact, possèdent une forme arquée (21) présentant au moins un arc (20), et **en ce que** l'au moins un arc (20) de la forme arquée (21) est situé dans un plan défini par la longueur L de l'élément de contact (1) et par la largeur B de l'élément de contact (1).

2. Élément de contact selon la revendication 1, **caractérisé en ce que** la longueur 1 d'une lamelle (12) est plus grande que sa largeur b.

3. Élément de contact selon l'une quelconque des revendications précédentes, **caractérisé en ce que** la largeur b d'une lamelle (12) est plus grande que sa profondeur t.

4. Élément de contact selon l'une quelconque des revendications précédentes, **caractérisé en ce que** la section transversale de la totalité de l'élément de contact est essentiellement réalisée de manière rectangulaire.

5. Élément de contact selon l'une quelconque des revendications précédentes, **caractérisé en ce que** la section transversale d'au moins une des lamelles (12) est essentiellement réalisée de manière rectangulaire.

6. Élément de contact selon l'une quelconque des revendications précédentes, **caractérisé en ce que** son épaisseur D forme la largeur b d'au moins une des lamelles (12).

7. Élément de contact selon l'une quelconque des revendications précédentes, **caractérisé en ce qu'**il est constitué d'un matériau élastique.

8. Élément de contact selon l'une quelconque des revendications précédentes, **caractérisé en ce que** l'aire de la section transversale et/ou la forme de section transversale d'une lamelle (12) est/sont différente(s) sur son étendue longitudinale.

9. Élément de contact selon l'une quelconque des revendications précédentes, **caractérisé en ce que** les aires de section transversale et/ou les formes de section transversale des lamelles (12) sont différentes entre elles.

10. Élément de contact selon l'une quelconque des revendications précédentes, **caractérisé en ce qu'**une partie terminale (2), notamment côté échantillon, présente une première zone de mise en contact (16) située - par rapport à la largeur B de l'élément de contact (1) - de manière excentrique.

11. Élément de contact selon l'une quelconque des revendications précédentes, **caractérisé en ce que** l'autre partie terminale (3) présente une deuxième zone de mise en contact (17) située - par rapport à la largeur B de l'élément de contact (1) - de manière centrique.

12. Élément de contact selon l'une quelconque des revendications précédentes, **caractérisé en ce que** la première et/ou la deuxième zones de mise en contact (16, 17) présentent une ou respectivement une pointe de contact (18, 19) se rétrécissant des deux côtés.

13. Élément de contact selon l'une quelconque des revendications précédentes, **caractérisé en ce qu'**il possède deux grands côtés (7, 8) dont un présente une allure coudée pour la formation d'un décalage latéral d'une partie terminale (2).

14. Élément de contact selon la revendication 13, **caractérisé en ce qu'**un gradin de retenue (15) est formé par l'allure coudée d'un grand côté.

15. Élément de contact selon l'une quelconque des revendications précédentes, **caractérisé par** au moins une section qui est munie d'un revêtement électriquement isolant et/ou d'un revêtement de mise en contact.

16. Élément de contact selon l'une quelconque des revendications précédentes, **caractérisé en ce qu'**au moins une des parties terminales (2, 3) présente une courbe et/ou une inclinaison qui est orientée de manière inverse à l'arc (20) de la forme arquée (21).

17. Élément de contact selon l'une quelconque des revendications précédentes, **caractérisé en ce qu'**au moins une des parties terminales (2, 3) présente une section transversale essentiellement rectangulaire.

18. Élément de contact selon la revendication 10, **caractérisé en ce que** la partie terminale (2) située de manière excentrique présente une section transversale essentiellement rectangulaire.

19. Élément de contact selon l'une quelconque des revendications précédentes, **caractérisé en ce que** les lamelles (12) présentent différentes longueurs 1 et/ou différentes formes arquées.

20. Agencement de mise en contact électrique comprenant au moins un élément de contact (1) selon l'une quelconque des revendications précédentes et comprenant un support d'élément de contact (23) qui présente au moins deux guidages (24) distancés les uns des autres pour l'élément de contact (1), dont au moins un possède un passage de guidage (26) qui est traversé par l'élément de contact (1).

21. Agencement de mise en contact selon la revendication 20, **caractérisé en ce qu'**au moins un des passages de guidage (26) présente une section transversale essentiellement rectangulaire.

22. Agencement de mise en contact selon l'une quelconque des revendications 20 à 21, **caractérisé en ce que** le passage de guidage (26) présentant une section transversale rectangulaire présente quatre parois de passage de guidage, dont une première paroi de passage de guidage (28) est située à l'opposé d'une deuxième paroi de passage de guidage (29).

23. Agencement de mise en contact selon l'une quelconque des revendications 20 à 22, **caractérisé en ce que** l'élément de contact (1), à l'état détendu non mis en contact, est maintenu dans le passage de guidage (26) de manière à ce que l'un des grands côtés (8, 7) de l'élément de contact (1) soit adjacent à un endroit de la première paroi de passage de guidage (28) et que l'autre des grands côtés (7, 8) de l'élément de contact (1) soit adjacent à un endroit de la deuxième paroi de passage de guidage (29), les deux endroits présentant un écart axial l'un par rapport à l'autre.

24. Agencement de mise en contact selon l'une quelconque des revendications 20 à 23, **caractérisé en ce que** l'élément de contact (1), à l'état tendu mis en contact, est maintenu dans le passage de guidage (26) de manière à ce que le grand côté (8, 7), adjacent jusqu'alors à l'endroit de la première paroi de passage de guidage (28) à l'état tendu, soit désormais adjacent à un autre endroit de la première paroi de passage de guidage (28) et que le grand côté (7, 8) de l'élément de contact (1), adjacent jusqu'alors à l'endroit de la deuxième paroi de passage de guidage (29), soit désormais adjacent à un autre endroit de la deuxième paroi de passage de guidage (29).
